# EUROPÄISCHE PATENTSCHRIFT

(11) **EP 2 681 761 B1**
(45) Veröffentlichungstag und Bekanntmachung des Hinweises auf die Patenterteilung: **19.02.2020**
(21) Anmeldenummer: 12706586.0
(22) Anmeldetag: 29.02.2012
(51) Int. Cl.: H01L 21/68, B41F 15/06, H05K 3/12

(54) **BEARBEITUNGSSTATION FÜR FLÄCHIGE SUBSTRATE, INSBESONDERE SOLARZELLEN**
PROCESSING STATION FOR FLAT SUBSTRATES, IN PARTICULAR SOLAR CELLS
POSTE DE TRAITEMENT POUR SUBSTRATS PLANS, EN PARTICULIER DES CELLULES SOLAIRES

(30) Priorität: 04.03.2011 DE 102011005157
(43) Veröffentlichungstag der Anmeldung: 08.01.2014
(73) Patentinhaber: JRT Photovoltaics GmbH & Co. KG, 79364 Malterdingen (DE)
(72) Erfinder: REICHENBACH, Michael, 79183 Waldkirch (DE)
(74) Vertreter: Patentanwälte Ruff, Wilhelm, Beier, Dauster & Partner mbB
(86) Internationale Anmeldenummer: PCT/EP2012/053448
(87) Internationale Veröffentlichungsnummer: WO 2012/119904

(56) Entgegenhaltungen:
- WO-A1-2008/081981
- WO-A1-2011/003484
- WO-A2-2005/004208
- DE-A1-102006 034 455
- GB-A- 2 458 313
- JP-A- 61 143 144
- US-A- 6 012 388

## Beschreibung

Die Erfindung betrifft eine Druckstation für flächige Substrate, insbesondere Solarzellen, mit einer Werkstückauflage mit einer Auflagefläche für ein zu bearbeitendes Werkstück und einem Druckwerk, das ein relativ zur Auflagefläche der Werkstückauflage verschiebbares Drucksieb aufweist. Die Erfindung betrifft auch ein Verfahren zum Bedrucken von flächigen Substraten.

Aus der US-Patentschrift 6,012,388 ist eine Siebdruckstation bekannt, die eine Werkstückauflage mit einer Auflagefläche für ein zu bedruckendes Werkstück und ein Druckwerk aufweist, das ein relativ zur Auflagefläche der Werkstückauflage verschiebbares Drucksieb aufweist. Das Drucksieb ist in einen Rahmen eingespannt und der Rahmen kann an zwei gegenüberliegenden Seiten mittels Druckluftzylindern parallel zur Siebfläche kraftbeaufschlagt werden. Durch eine solche Kraftbeaufschlagung kann der Rahmen des Drucksiebs und damit auch das Drucksieb selbst verformt werden, um Form und Abmessungen der Sieböffnungen zu verändern.

Aus der japanischen Patentzusammenfassung JP 61143144 ist eine Siebdruckstation für flächige Substrate mit einer Werkstückauflage mit einer Auflagefläche für ein zu bearbeitendes Werkstück und einem Druckwerk bekannt. Das Druckwerk weist ein relativ zur Auflagefläche der Werkstückauflage verschiebbares Drucksieb auf. Vor dem Siebdrucken wird das Drucksieb ausgerichtet und kann dann mittels Luftdruck, speziell Unterdruck, während des Druckvorgangs fixiert werden.

Aus der deutschen Offenlegungsschrift DE 10 2006 034 455 A1 ist eine Werkstückauflage für eine Maschine bekannt. Die Werkstückauflage kann in Höhenrichtung mittels Luftlagern gelagert sein und ist entlang eines Kanals verschiebbar.

Mit der Erfindung soll eine Druckstation für flächige Substrate und ein Verfahren verbessert werden.

Erfindungsgemäß ist hierzu eine Druckstation für flächige Substrate, insbesondere Solarzellen, mit einer Werkstückauflage, insbesondere einem Drucknest, mit einer Auflagefläche für ein zu bearbeitendes Substrat und einem Druckwerk, das ein relativ zur Auflagefläche der Werkstückauflage verschiebbares Drucksieb, aufweist, vorgesehen, bei dem das Drucksieb mittels Luftlagern verschiebbar gehalten ist, wobei die Luftlager ausgebildet sind, das Drucksieb wenigstens während eines Druckvorgangs verschiebbar zu halten.

Das Vorsehen von Luftlagern für das Drucksieb, ermöglicht eine hochpräzise Einstellung der Lage des Drucksiebes vor und während der Bearbeitung, dies speziell deshalb, da mit Luftlagern eine im Wesentlichen reibungsfreie Lagerung des Drucksiebs erzielt werden kann und infolgedessen keine stick-slip-Effekte beim Ausrichten des Drucksiebes auftreten. Die Luftlager sind somit auch während des Bearbeitungsvorgangs selbst aktiv, um erforderlichenfalls das Bearbeitungswerkzeug zu verschieben. Bei reibungsbehafteten Lagern, beispielsweise konventionellen Gleitlagern, äußert sich der stick-slip-Effekt darin, dass bei jeder Verschiebung ausgehend von der Ruhelage zunächst ein Losbrechmoment überwunden werden muss, um den Übergang von der Haftreibung in die Gleitreibung beim Verschieben zu bewirken. Wird das Bearbeitungswerkzeug mehrfach verstellt bzw. reguliert, so führt das Auftreten dieses Losbrecheffektes bzw. stick-slip-Effektes zu Toleranzen bei der Lagepositionierung, die bei Präzisionsanwendungen nicht mehr akzeptabel sind. Speziell beim Bedrucken von Solarzellen, beispielsweise mit Leiterbahnen, müssen die oft nur Bruchteile von Millimetern breiten Leiterbahnen in mehreren Schichten aufgedruckt werden. Dadurch werden sehr hohe Anforderungen an die Lagegenauigkeit des Drucksiebes relativ zu der zu bedruckenden Solarzelle auf der Auflagefläche des Drucknests gestellt. Das Vorsehen von Luftlagern zum verschiebbaren Halten des Drucksiebs vermeidet die stick-slip-Effekte bei der Positionierung des Drucksiebs und erlaubt es daher, beim Bedrucken von flächigen Werkstücken sehr geringe Toleranzen einzuhalten. Die Bearbeitungsstation kann beispielsweise als Druckstation ausgebildet sein, mit einem Drucknest als Werkstückauflage und einem Drucksieb als Bearbeitungswerkzeug.

In Weiterbildung der Erfindung sind die Luftlager magnetisch vorbespannt, mittels Schwerkraft vorgespannt oder doppelseitig ausgebildet.

In dem die Luftlager vorgespannt oder doppelseitig ausgebildet sind, kann ein sehr präziser Lagerspalt der Luftlager gewährleistet werden, der für die vorgesehene Präzisionsanwendung von großer Bedeutung ist. Darüber hinaus ist es durch die Vorspannung in eine Ruhelage, in der sich die beiden Lagerflächen bei abgeschalteter Luftzufuhr berühren oder die doppelseitige Ausführung, auch möglich, mit dem Luftlager nicht nur Schubkräfte sondern auch Zugkräfte zu übertragen. Dies ermöglicht es beispielsweise, das Drucksieb bzw. den Halterahmen eines Drucksiebes unter Zwischenschaltung der Luftlager in zwei einander entgegengesetzten Richtungen zu verschieben, auch wenn die Luftlager nur an einer einzigen Seite des Halterahmens des Drucksiebes angreifen.

In Weiterbildung der Erfindung ist das Drucksieb mittels der Luftlager parallel zur Auflagefläche verschiebbar gehalten.

Auf diese Weise kann beispielsweise die Position einer zu bedruckenden Solarzelle auf der Auflagefläche erfasst und die Position des Drucksiebes an diese erfasste Position angepasst werden. Dies geschieht dann mittels einer Verschiebung des Drucksiebes parallel zur Auflagefläche.

In Weiterbildung der Erfindung sind Aktoren vorgesehen, um das Drucksieb relativ zur Auflagefläche der Werkstückauflage zu verschieben, wobei die Aktoren unter Zwischenschaltung von Luftlagern an Haltevorrichtungen für das Drucksieb angreifen.

Indem die Aktoren unter Zwischenschaltung von Luftlagern an Haltevorrichtungen für das Drucksieb, angreifen, können beim Positionieren bzw. Bewegen des Drucksiebes stick-slip-Effekte vermieden werden. Neben einer hochpräzisen Positionierung zum Ausrichten des Drucksiebs relativ zu einem zu bedruckenden Substrat kann dadurch auch eine während des Druckvorgangs ggf. erforderliche Bewegung des Drucksiebs mit geringen Toleranzen ausgeführt werden. Eine solche Bewegung des Drucksiebes während des Druckvorgangs kann vorteilhaft sein, um einen Siebverzug beim Druckvorgang, verursacht durch die Druckrakel, zu kompensieren. Als Aktoren können beispielsweise Hydraulikzylinder, Pneumatikzylinder, Elektromotoren, Elektromagnete oder auch Piezoelemente, Spindelantriebe, Direktantriebe wie Linearmotoren und dergleichen eingesetzt werden.

In Weiterbildung der Erfindung sind die Aktoren wenigstens teilweise dafür vorgesehen, um das Drucksieb aus einer parallel zu der Auflagefläche der Werkstückauflage angeordneten Ebene heraus zu bewegen.

Die Aktoren können beispielsweise das Drucksieb in eine Druckstellung auf oder kurz oberhalb des zu bedruckenden Werkstücks absenken. Darüber hinaus kann mittels der Aktoren auch ein sogenannter Sieblift erzielt werden, bei dem also während der Bewegung der Druckrakel über das Drucksieb dieses hinter der Druckrakel leicht angehoben wird, um das Drucksieb rasch aus der aufgedruckten Farbe herauszuheben. Dies wird durch ein Anheben der in Bezug auf die Druckbewegung der Druckrakel hinten liegende Seite des Drucksiebes erreicht.

In Weiterbildung der Erfindung sind die Aktoren wenigstens teilweise dafür vorgesehen, um das Drucksieb parallel zu der Auflagefläche der Werkstückauflage zu verschieben.

Auf diese Weise kann, beispielsweise beim Bedrucken von Solarzellen, das Drucksieb auf eine Position der Solarzelle auf der Auflagefläche ausgerichtet werden. Gerade bei empfindlichen zu bedruckenden Werkstücken ist es vorteilhaft, nicht das zu bedruckende Werkstück selbst zu verschieben, sondern stattdessen das Drucksieb auf die Position des Werkstücks auszurichten.

In Weiterbildung der Erfindung greifen die Aktoren unter Zwischenschaltung von jeweils einem Luftlager und jeweils einem Kugelgelenk oder einem Festkörpergelenk an den Haltevorrichtungen für das Drucksieb an.

Auf diese Weise kann die Einleitung von Drehmomenten in das Luftlager vermieden werden und es kann sichergestellt werden, dass das Luftlager als einwertiges Lager wirkt, also die Bewegung der gelagerten Fläche lediglich in einer Raumrichtung einschränkt. Mit Festkörpergelenk wird ein annähernd biegeweicher Stab bezeichnet, der Schub- und Zugkräfte parallel zu seiner Längsachse aber nur unwesentliche Kräfte senkrecht zur Längsachse und unwesentliche Biegemomente übertragen kann.

In Weiterbildung der Erfindung greifen wenigstens drei Aktoren an den Haltevorrichtungen für das Drucksieb an, um eine Verschiebekraft parallel zur Auflagefläche der Werkstückauflage zu bewirken.

Durch eine Vorspannung der Luftlager oder doppelseitige Luftlager kann das Drucksieb mit den drei Aktoren in alle Richtungen parallel zur Auflagefläche des Drucknests verschoben werden, da dadurch mit den Aktoren auch Zugkräfte ausgeübt werden können.

In Weiterbildung der Erfindung greifen wenigstens drei Aktoren an den Haltevorrichtungen für das Drucksieb an, um eine Verschiebekraft senkrecht zur Auflagefläche der Werkstückauflage zu bewirken.

Prinzipiell reichen drei Aktoren für die Erzeugung einer Verschiebekraft senkrecht zur Auflagefläche des Drucknests aus, auch um das Drucksieb beispielsweise zu verkippen. Vorteilhafterweise sind die Haltevorrichtungen als um das Bearbeitungswerkzeug umlaufende Halterahmen ausgebildet und die Aktoren greifen wenigstens teilweise im Bereich der vier Ecken des Halterahmens an.

In Weiterbildung der Erfindung sind die Aktoren auf einer, der Auflagefläche der Werkstückauflage gegenüberliegenden Seite der Haltevorrichtungen angeordnet.

Auf diese Weise können auch große Aktoren verwendet werden, da oberhalb des Drucksiebs genügend Platz zur Verfügung steht und beispielsweise nicht die Gefahr besteht, dass die Aktoren in den Bewegungsraum eines unter dem Drucksieb angeordneten Rundschalttisches mit den Drucknestern hineinragen.

In Weiterbildung der Erfindung weisen die Haltevorrichtungen für das Drucksieb parallel zum Drucksieb angeordnete Lagerplatten auf und jeder Lagerplatte ist ein U-förmiger Haltebügel zugeordnet, der die jeweilige Lagerplatte abschnittsweise umgreift.

Durch Vorsehen von Lagerplatten und U-förmigen Haltebügeln lässt sich die Anordnung der Aktoren oberhalb des Drucksiebes mit einer vergleichsweise einfach ausgebildeten Luftlagerung des Drucksiebes verbinden. Vorteilhafterweise ist das Luftlager zwischen einer Innenseite eines ersten Schenkels des Haltebügels und der Lagerplatte angeordnet und der Aktor greift an einer Außenseite eines zweiten Schenkels des Haltebügels an. Vorteilhafterweise ist der Aktor mittels eines Kugelgelenks oder eines Festkörpergelenks mit dem zweiten Schenkel des Haltebügels verbunden.

Auf diese Weise kann eine sehr platzsparende Anordnung der Aktoren verwirklicht werden und gleichzeitig kann sichergestellt werden, dass das Drucksieb mittels mehrerer einwertiger Lager gehalten ist und dadurch nicht das Aufbringen eines Biegemoments auf das Drucksieb bzw. dessen Haltevorrichtungen zu befürchten ist, die wiederum Toleranzen bei der Positionierung des Drucksiebes verursachen könnten.

Weiter Merkmale und Vorteile der Erfindung ergeben sich aus den Ansprüchen und der folgenden Beschreibung bevorzugter Ausführungsformen der Erfindung im Zusammenhang mit den Zeichnungen. Einzelmerkmale der unterschiedlichen dargestellten und/oder beschriebenen Ausführungsformen lassen sich dabei in beliebiger Weise miteinander kombinieren ohne den Rahmen der Erfindung zu überschreiten. In den Zeichnungen zeigen:
- Fig. 1: eine schematische Darstellung eines Drucksiebes mit Halter-ahmen gemäß der Erfindung,
- Fig. 2: eine Seitenansicht des Drucksiebes der Fig. 1,
- Fig. 3: eine weitere Seitenansicht des Drucksiebes der Fig. 1,
- Fig. 4: eine Draufsicht auf das Drucksieb der Fig. 1,
- Fig. 5: eine Aufsicht auf die Schnittebene A-A in Fig. 2,
- Fig. 6: eine Aufsicht auf den Schnittverlauf B-B in Fig. 4 und
- Fig. 7: eine schematische Ansicht einer erfindungsgemäßen Druck-station von schräg oben.

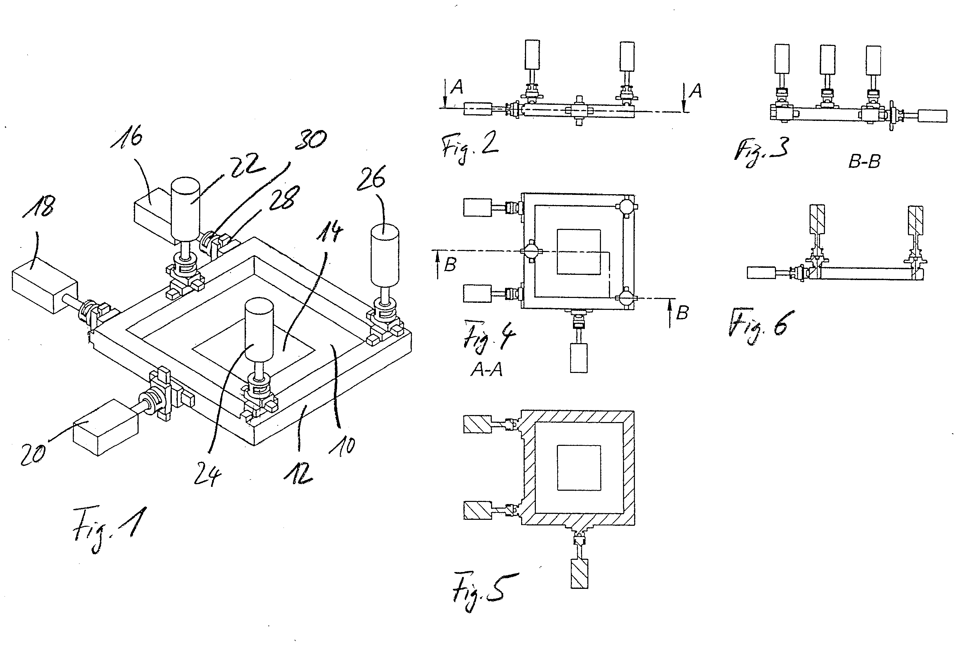

Die Darstellung der Fig. 1 zeigt schematisch ein Drucksieb 10, das an einem Halterahmen 12 befestigt ist und zum Bedrucken einer ebenfalls schematisch dargestellten Solarzelle 14 vorgesehen ist. Um das Drucksieb 10 zusammen mit dem Halterahmen 12 in einer Ebene auszurichten, die parallel zur Eben der Solarzelle 14 liegt, sind insgesamt drei Aktoren 16, 18 und 20 vorgesehen. Um das Drucksieb 10 mit dem Halterahmen 12 senkrecht zur Solarzelle 14 zu bewegen bzw. relativ zur Solarzelle 14 zu verkippen, sind weitere drei Aktoren 22, 24 und 26 vorgesehen. Die Aktoren 22, 24 und 26 greifen an einer Oberseite des Halterahmens 12 an, wohingegen die Aktoren 16, 18 und 20 an Seitenkanten des Halterahmens 12 angreifen. Die beiden Aktoren 16, 18 greifen im Bereich der äußeren Enden einer Seitenkante des Halterahmens 12 an, wohingegen der Aktor 20 in der Mitte einer senkrecht zur ersten Seitenkante liegenden Seitenkante des Halterahmens 12 angreift. Der Aktor 22 greift an der Oberseite des Halterahmens 12 zwischen den Angreifpunkten der Aktoren 16 und 18 an. Die beiden Aktoren 24, 26 greifen jeweils an einer Ecke der Oberseite des Halterahmens 12 an, die den beiden Aktoren 16, 18 gegenüberliegt. Die Aktoren 16, 18, 20, 22, 24 und 26 greifen jeweils mittels eines einwertigen Lagers an dem Halterahmen 12 an. Dies ist jeweils durch eine Kreuzführung 28 sowie jeweils ein Kugelgelenk 30 symbolisiert. Die Aktoren 16, 18, 20, 22, 24, 26 greifen somit jeweils unter Zwischenschaltung eines Kugelgelenks 30 sowie eines durch die Kreuzführung 28 symbolisierten einwertigen Lagers an dem Halterahmen 12 an.

Unter einem einwertigen Lager ist zu verstehen, dass der Halterahmen 12 lediglich in einer einzigen Raumrichtung in seiner Bewegung beschränkt wird. Das Vorsehen des Kugelgelenks 30 symbolisiert, dass keine Drehmomente in das durch die Kreuzführung 28 symbolisierte einwertige Lager eingebracht werden können. Vorteilhafterweise werden die Kreuzführungen 28 als reibungsfreie Lager, beispielsweise als Luftlager ausgebildet, die vorteilhafterweise magnetisch oder mittels Schwerkraft vorgespannt oder doppelseitig ausgebildet sind. Auf diese Weise kann sowohl das Anheben des Halterahmens 12 mit dem Drucksieb 10 als auch dessen Positionierung ohne störende stick-slip-Effekte bewirkt werden. Jede von den Aktoren 16, 18, 20, 22, 24, 26 aufgebrachte Kraft wird somit in eine Verschiebung des Halterahmens 12 umgesetzt, da aufgrund der im Wesentlichen reibungsfreien Ausgestaltung der Luftlager keine Losbrechkraft überwunden werden muss, um eine Haftreibung zwischen den Lagerflächen zu überwinden. Auf diese Weise ist eine hochpräzise Einstellung des Halterahmens 12 mit dem Drucksieb 10 relativ zur zu bedruckenden Solarzelle 14 möglich.

Die Darstellungen der Fig. 2 bis 6 zeigen verschiedene Ansichten der Anordnung aus Fig. 1.

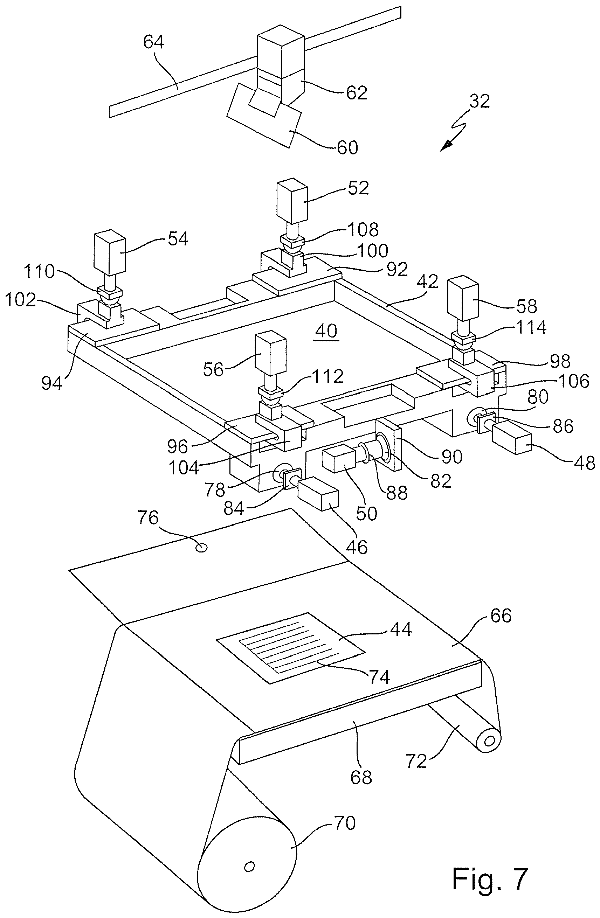

In Fig. 7 ist eine Druckstation 32 gemäß einer bevorzugten Ausführungsform der Erfindung schematisch dargestellt. Die Druckstation 32 weist ein Drucksieb 40 auf, das in einem Halterahmen 42 angeordnet ist. Das Drucksieb 40 muss dabei nicht unmittelbar an dem Halterahmen 42 befestigt sein, sondern ist zweckmäßigerweise mit einem eigenen Siebrahmen versehen, der dann wiederum an dem Halterahmen 42 befestigt ist. Eine solche Befestigung des Drucksiebes 40 ist der Übersichtlichkeit halber in Fig. 7 aber nicht dargestellt. Das Drucksieb 40 ist zum Bedrucken einer Solarzelle 44 vorgesehen.

Der Halterahmen 42 des Drucksiebs 40 ist mittels drei Aktoren 46, 48, 50 in einer Ebene parallel zu einer Auflagefläche verstellbar, auf der die Solarzelle 44 aufliegt. Mittels insgesamt vier Aktoren 52, 54, 56, 58 ist der Halterahmen 42 mit dem Drucksieb 40 senkrecht zu dieser Auflagefläche verstellbar oder beispielsweise auch zu der Auflagefläche verkippbar.

Die Druckstation 32 weist weiter eine Druckrakel 60 auf, die mittels eines Pneumatikzylinders 62 angehoben und abgesenkt werden kann und an einer Rakelführung 64 im Wesentlichen parallel zur Auflagefläche, auf der die Solarzelle 44 aufliegt, verschiebbar ist.

Die Solarzelle 44 liegt auf einem flexiblen Transportband 66 auf, beispielsweise ein Papierband, das über die Oberseite eines Drucknests 68 geführt ist. Die Oberseite des Drucknests 68 bzw. die Oberseite des Transportbandes 66 definieren dadurch die Auflagefläche, auf der die Solarzelle 44 aufliegt. Das Transportband 66 ist ausgehend von einer ersten Rolle 70 über die Oberseite des Drucknests 68 zu einer zweiten Rolle 72 geführt. Das Transportband 66 kann in zwei zueinander entgegengesetzten Richtungen bewegt werden und wird infolgedessen von der Rolle 70 entweder abgewickelt oder auf diese aufgewickelt. Das Transportband 66 dient dadurch nicht nur als Druckunterlage sondern gleichzeitig auch als Transportband, um zu bedruckende Solarzellen 44 auf das Drucknest 68 zu befördern bzw. um bereits bedruckte Solarzellen 44 vom Drucknest 68 abzufördern. Auf der Solarzelle 44 sind schematisch Leiterbahnen 74 angedeutet, die mit dem Drucksieb 40 und der Druckrakel 60 aufgedruckt werden. Das Drucknest 68 ist an einem Rundschalttisch befestigt, der jedoch lediglich schematisch durch eine Drehachse 76 symbolisiert ist. Das Drucknest 68 kann sich dadurch um die Drehachse 76 drehen und es sind weitere, nicht dargestellte Drucknester vorhanden, die nacheinander unter das Drucksieb 40 gefahren werden können.

Die Aktoren 46, 48 und 50 sind dafür vorgesehen, Verschiebekräfte auf den Halterahmen 42 aufzubringen, die parallel zur Auflagefläche des Drucknests 68 liegen. Die Aktoren 46, 48, 50 sind jeweils mittels Luftlager 78, 80, 82 mit dem Halterahmen verbunden, wobei zwischen dem jeweiligen Luftlagern 78, 80, 72 und dem jeweiligen Aktor 46, 48, 50 ein Kugelgelenk 84, 86, 88 vorgesehen ist. Die drei Aktoren 46, 48, 50 greifen alle an einer Seitenkante des Halterahmens 42 an, die in Bezug auf die Drehachse 76 des Rundschalttisches radial außen liegt. Auf diese Weise kann eine platzsparende Anordnung realisiert werden, wobei an der radial außen liegenden Seite des Halterahmens 42 genügend Platz zur Verfügung steht. Die Luftlager 78, 80, 72 sind magnetisch in eine Ruhelage, in der sich die Lagerflächen bei abgeschalteter Luftzufuhr berühren, vorgespannt und können dadurch nicht nur Schubkräfte sondern auch Zugkräfte senkrecht zu den Lagerflächen übertragen. Die Aktoren 46, 48 greifen im Bereich der einander gegenüberliegenden Ecken der radial außen liegenden Seitenkante des Halterahmens 42 an und sind dafür vorgesehen, im Wesentlichen in radialer Richtung zur Drehachse 76 wirkende Verschiebekräfte auf den Halterahmen 42 aufzubringen. Der Aktor 50 greift an einer Lagerplatte 90 des Halterahmens 42 an, die sich im Wesentlichen in radialer Richtung erstreckt und zwischen den Angreifpunkten der beiden Aktoren 46, 48 angeordnet ist. Mittels des Aktors 50 können im Wesentlichen tangential zur Drehachse 76 liegende Verschiebekräfte auf den Halterahmen 42 aufgebracht werden.

Die vier Aktoren 52, 54, 56, 58 sind zum Aufbringen von Haltekräften bzw. Verschiebekräften auf den Halterahmen 42 vorgesehen, die im Wesentlichen senkrecht zur Auflagefläche des Drucknests 68 und damit im Wesentlichen parallel zur Drehachse 76 liegen. Jeder der Aktoren 52, 54, 56, 58 greift im Bereich einer parallel zum Drucksieb 40 angeordneten Lagerplatte 92, 94, 96, 98 an, wobei die Lagerplatten 92, 94, 96, 98 jeweils im Bereich einer Ecke des Halterahmens 42 angeordnet sind. Die Lagerplatten 92, 94, 96, 98 werden von jeweils einem U-Bügel 100, 102, 104, 106 teilweise umgriffen, so dass die Lagerplatten 92, 94, 96, 98 abschnittsweise in dem jeweiligen U-Bügel 100, 102, 104, 106 aufgenommen sind. Die Lagerplatten 92, 94, 96, 98 liegen jeweils auf einer Innenseite eines in der Darstellung der Fig. 7 unteren Schenkels der U-Bügel 100, 102, 104, 106 unter Zwischenschaltung eines Luftlagers auf. Die Aktoren 52, 54, 56, 58 greifen jeweils unter Zwischenschaltung eines Kugelgelenks 108, 110, 112, 114 an einer in Fig. 7 oben liegenden Außenseite des gegenüberliegenden Schenkels des jeweiligen U-Bügels 100, 102, 104, 106 an. Das Vorsehen der Lagerplatten 92, 94, 96, 98 und der U-Bügel 100, 102, 104, 106 sowie die gewählte Anordnung der Luftlager und der Aktoren 52, 54, 56, 58 stellt eine im Wesentlichen reibungsfreie Lagerung des Halterahmens 42 mit dem Drucksieb 40 in einer Ebene parallel zur Auflagefläche des Drucksieb 68 sicher. Diese reibungsfreie Lagerung ermöglicht wiederum eine äußerst präzise Ausrichtung des Drucksiebs 40 relativ zu der Auflagefläche des Drucknests 68, die durch das Papierband 66 gebildet ist, und der darauf aufliegenden Solarzelle 44 mittels der Aktoren 46, 48, 50 sicher. Mit der erfindungsgemäßen Druckstation 32 lassen sich die Leiterbahnen 74 der Solarzelle 44 damit mit äußerst hoher Präzision aufdrucken. Speziell können die Leiterbahnen 74 durch mehrere aufeinanderfolgende Druckvorgänge in Schichten aufgebracht werden, wobei die Lagetoleranz, der mehreren, nacheinander aufgebrachten Schichten extrem gering ist.

Das in Fig. 7 dargestellte Drucksieb 40 ist mittels der Aktoren 46, 48, 50 und der Aktoren 52, 54, 56, 58 in allen drei Raumrichtungen im Wesentlichen beliebig bewegbar. Dies ermöglicht es, während des Drucks, also während einer Bewegung der Druckrakel 60 über das Drucksieb 40 hinweg, alle Druckparameter, beispielsweise Siebspannung und Auslösewinkel, konstant zu halten. Dies wird im Einzelnen dadurch bewerkstelligt, dass die jeweilige Position der Druckrakel 60, speziell die Kontaktlinie zwischen Druckrakel 60 und Drucksieb 40, eine Masterachse darstellt und durch Verkippen des Drucksiebs 40 um diese Masterachse die Druckparameter Siebspannung und Siebauslösewinkel während der Bewegung der Druckrakel 60 konstant gehalten werden. Die Siebspannung entsteht aus einer Siebdehnung, die über einen variablen Hub in z-Richtung, in Fig. 7 also auf das Drucknest 68 zu oder von diesem weg, bewirkt wird. Der Siebauslösewinkel, also ein Winkel, den das Drucksieb 40 hinter der Rakel relativ zur Auflagefläche des Drucknests 68 einnimmt, ergibt sich aus einer Schrägstellung/Neigung des Drucksiebes 40, die durch variable z-Hübe der Aktoren 52, 54, 56, 58 eingestellt werden kann. Weitere Bewegungen des Drucksiebes 40 können sinnvoll sein, um beispielsweise während der Bewegung der Rakel 60 einen Siebverzug zu kompensieren, wobei hierzu auch eine Bewegung des Drucksiebes 40 mittels der Aktoren 46, 48, 50 durchgeführt werden kann.

## Patentansprüche

1. Druckstation für flächige Substrate, insbesondere Solarzellen (14, 44), mit einer Werkstückauflage (68) mit einer Auflagefläche für ein zu bearbeitendes Substrat und einem Druckwerk, das ein relativ zur Auflagefläche der Werkstückauflage (68) verschiebbares Drucksieb (10; 40) aufweist, **dadurch gekennzeichnet, dass** das Drucksieb (10; 40) mittels Luftlagern (78, 80, 82) verschiebbar gehalten ist, wobei die Luftlager (78, 80, 82) ausgebildet sind, das Drucksieb (10; 40) wenigstens während eines Druckvorgangs verschiebbar zu halten.

2. Druckstation nach Anspruch 1, **dadurch gekennzeichnet, dass** die Luftlager magnetisch vorgespannt, durch Schwerkraft vorgespannt oder doppelseitig ausgebildet sind.

3. Druckstation nach Anspruch 1 oder 2, **dadurch gekennzeichnet, dass** das Drucksieb (10; 40) mittels der Luftlager (78, 80, 82) parallel zur Auflagefläche verschiebbar gehalten ist.

4. Druckstation nach einem der vorstehenden Ansprüche, **dadurch gekennzeichnet, dass** Aktoren (16, 18, 20, 22, 24, 26; 46, 48, 50, 52, 54, 56, 58) vorgesehen sind, um das Drucksieb (10; 40) relativ zur Auflagefläche der Werkstückauflage (68) zu verschieben, wobei die Aktoren unter Zwischenschaltung der Luftlager (78, 80, 82) an Haltevorrichtungen für das Drucksieb (10; 40) angreifen.

5. Druckstation nach Anspruch 4, **dadurch gekennzeichnet, dass** die Aktoren (22, 24, 26; 52, 54, 56, 58) wenigstens teilweise dafür vorgesehen sind, um das Drucksieb (10; 40) aus einer parallel zu der Auflagefläche der Werkstückauflage (68) angeordneten Ebene herauszubewegen.

6. Druckstation nach Anspruch 4 oder 5, **dadurch gekennzeichnet, dass** die Aktoren (16, 18, 20; 46, 48, 50) wenigstens teilweise dafür vorgesehen sind, um das Drucksieb (10; 40) parallel zu der Auflagefläche der Werkstückauflage (68) zu verschieben.

7. Druckstation nach einem der vorstehenden Ansprüche 4 bis 6, **dadurch gekennzeichnet, dass** die Aktoren (46, 48, 50, 52, 54, 56, 58) unter Zwischenschaltung von jeweils einem Luftlager (78, 80, 82) und jeweils einem Kugelgelenk (84, 86, 88, 108, 110, 112, 114) oder einem Festkörpergelenk an den Haltevorrichtungen für das Drucksieb (10; 40) angreifen.

8. Druckstation nach einem der vorstehenden Ansprüche 4 bis 7, **dadurch gekennzeichnet, dass** wenigstens drei Aktoren (16, 18, 20; 46, 48, 50) an den Haltevorrichtungen für das Drucksieb (10; 40) angreifen, um eine Verschiebekraft parallel zur Auflagefläche der Werkstückauflage (68) zu bewirken.

9. Druckstation nach einem der vorstehenden Ansprüche 4 bis 8, **dadurch gekennzeichnet, dass** wenigstens drei Aktoren (52, 54, 56, 58) an den Haltevorrichtungen für das Drucksieb (40) angreifen, um eine Verschiebekraft senkrecht zur Auflagefläche der Werkstückauflage (68) zu bewirken.

10. Druckstation nach Anspruch 9, **dadurch gekennzeichnet, dass** die Haltevorrichtungen einen um das Drucksieb (40) umlaufenden Halterahmen (42) aufweisen, wobei die Aktoren (52, 54, 56, 58) wenigstens teilweise im Bereich von Ecken des Halterahmens (42) angreifen.

11. Druckstation nach Anspruch 9 oder 10, **dadurch gekennzeichnet, dass** die Aktoren (52, 54, 56, 58) auf einer, der Auflagefläche der Werkstückauflage (68) gegenüberliegenden Seite der Haltevorrichtungen angeordnet sind.

12. Druckstation nach einem der vorstehenden Ansprüche, **dadurch gekennzeichnet, dass** die Haltevorrichtungen für das Drucksieb (40) parallel zum Drucksieb (40) angeordnete Lagerplatten (92, 94, 96, 98) aufweisen und jeder Lagerplatte (92, 94, 96, 98) ein u-förmiger Haltebügel (100, 102, 104, 106) zugeordnet ist, der die jeweilige Lagerplatte (92, 94, 96, 98) abschnittsweise umgreift.

13. Druckstation nach Anspruch 12, **dadurch gekennzeichnet, dass** das Luftlager zwischen einer Innenseite eines ersten Schenkels des Haltebügels (100, 102, 104, 106) und der Lagerplatte (92, 94, 96, 98) angeordnet ist.

14. Druckstation nach Anspruch 12 oder 13, **dadurch gekennzeichnet, dass** der Aktor (52, 54, 56, 58) an einer Außenseite eines zweiten Schenkels des Haltebügels (100, 102, 104, 106) angreift.

15. Verfahren zum Bedrucken flächiger Substrate, insbesondere Solarzellen (14, 44), mit einer Druckstation nach wenigstens einem der vorstehenden Ansprüche, **gekennzeichnet durch** Verschiebbarhalten des Drucksiebes (10; 40) mittels Luftlagern (78, 80, 82) und durch Verschieben des Drucksiebes (10; 40) relativ zu der Auflagefläche der Werkstückauflage (68) während des Druckvorgangs.

## Claims

1. Printing station for flat substrates, in particular solar cells (14, 44), comprising a workpiece support (68) having a support surface for a substrate to be processed and a printing mechanism including a printing screen (10; 40) displaceable relative to the support surface of the workpiece support (68), **characterized in that** the printing screen (10; 40) is held to be displaceable by means of air bearings (78, 80, 82), wherein the air bearings (78, 80, 82) are configured to hold the printing screen (10; 40) to be displaceable at least during a printing procedure.

2. Printing station according to claim 1, **characterized in that** the air bearings are magnetically pre-tensioned, pre-tensioned by gravity or have a double-sided design.

3. Printing station according to claim 1 or 2, **characterized in that** the printing screen (10; 40) is held by means of the air bearings (78, 80, 82) to be displaceable in parallel to the support surface.

4. Printing station according to any of the preceding claims, **characterized in that** actuators (16, 18, 20, 22, 24, 26; 46, 48, 50, 52, 54, 56, 58) are provided, to displace the printing screen (10; 40) relative to the support surface of the workpiece support (68), wherein the actuators engage on holding devices for the printing screen (10; 40) with the air bearings (78, 80, 82) interposed.

5. Printing station according to claim 4, **characterized in that** the actuators (22, 24, 26; 52, 54, 56, 58) are provided at least in part, to move the printing screen (10; 40) away from a plane that is disposed in parallel to the support surface of the workpiece support (68).

6. Printing station according to claim 4 or 5, **characterized in that** the actuators (16, 18, 20; 46, 48, 50) are provided at least in part, to displace the printing screen (10; 40) in parallel to the support surface of the workpiece support (68).

7. Printing station according to any of the claims 4 to 6, **characterized in that** the actuators (46, 48, 50, 52, 54, 56, 58) engage on the holding devices for the printing screen (10; 40) with in each case an air bearing (78, 80, 82) and in each case a ball joint (84, 86, 88, 108, 110, 112, 114) or a solid-state joint interposed.

8. Printing station according to any of the claims 4 to 7, **characterized in that** at least three actuators (16, 18, 20; 46, 48, 50) engage on the holding devices for the printing screen (10; 40), to cause a shifting force in parallel to the support surface of the workpiece support (68).

9. Printing station according to any of the claims 4 to 8, **characterized in that** at least three actuators (52, 54, 56, 58) engage on the holding devices for the printing screen (40), to cause a shifting force perpendicular to the support surface of the workpiece support (68).

10. Printing station according to claim 9, **characterized in that** the holding devices include a holding frame (42) circumferential about the printing screen (40), wherein the actuators (52, 54, 56, 58) engage at least partially in the region of corners of the holding frame (42).

11. Printing station according to claim 9 or 10, **characterized in that** the actuators (52, 54, 56, 58) are arranged on a side of the holding devices that is opposite to the support surface of the workpiece support (68).

12. Printing station according to any of the preceding claims, **characterized in that** the holding devices for the printing screen (40) include bearing plates (92, 94, 96, 98) disposed in parallel to the printing screen (40) and each bearing plate (92, 94, 96, 98) has a U-shaped mounting bracket (100, 102, 104, 106) assigned, which mounting bracket engages around the respective bearing plate (92, 94, 96, 98) in sections.

13. Printing station according to claim 12, **characterized in that** the air bearing is arranged between an inner side of a first leg of the mounting bracket (100, 102, 104, 106) and the bearing plate (92, 94, 96, 98).

14. Printing station according to claim 12 or 13, **characterized in that** the actuator (52, 54, 56, 58) engages on an outer side of a second leg of the mounting bracket (100, 102, 104, 106).

15. Method for printing flat substrates, in particular solar cells (14, 44), using a printing station according to at least one of the preceding claims, **characterized by** holding the printing screen (10; 40) to be displaceable by means of air bearings (78, 80, 82), and by displacing the printing screen (10; 40) relative to the support surface of the workpiece support (68) during the printing procedure.

## Revendications

1. Station d'impression destinée à des substrats bidimensionnels, en particulier des cellules solaires (14, 44), ladite station d'impression comprenant un support de pièce (68) présentant une surface de support destinée à un substrat à traiter et une unité d'impression qui comprend un écran d'impression (10 ; 40) déplaçable par rapport à la surface de support du support de pièce (68), **caractérisée en ce que** l'écran d'impression (10 ; 40) est maintenu de manière coulissante à l'aide de paliers à air (78, 80, 82), les paliers à air (78, 80, 82) étant conçus pour maintenir l'écran d'impression (10 ; 40) de manière coulissante au moins pendant une opération d'impression.

2. Station d'impression selon la revendication 1, **caractérisée en ce que** les paliers à air sont précontraints magnétiquement, précontraints par gravité ou conçus à double face.

3. Station d'impression selon la revendication 1 ou 2, **caractérisée en ce que** l'écran d'impression (10, 40) est maintenu de manière coulissante parallèlement à la surface de support à l'aide des paliers à air (78, 80, 82).

4. Station d'impression selon l'une des revendications précédentes, **caractérisée en ce que** des actionneurs (16, 18, 20, 22, 24, 26 ; 46, 48, 50, 52, 54, 56, 58) sont prévus pour faire coulisser l'écran d'impression (10 ; 40) par rapport à la surface de support du support de pièce (68), les actionneurs s'engageant sur des dispositifs de retenue de l'écran d'impression (10 ; 40) avec interposition des paliers à air (78, 80, 82).

5. Station d'impression selon la revendication 4, **caractérisée en ce que** les actionneurs (22, 24, 26 ; 52, 54, 56, 58) sont prévus au moins en partie pour déplacer l'écran d'impression (10, 40) hors d'un plan disposé parallèlement à la surface de support du support de pièce (68).

6. Station d'impression selon la revendication 4 ou 5, **caractérisée en ce que** les actionneurs (16, 18, 20 ; 46, 48, 50) sont prévus au moins en partie pour faire coulisser l'écran d'impression (10, 40) parallèlement à la surface de support du support de pièce (68).

7. Station d'impression selon l'une des revendications précédentes 4 à 6, **caractérisée en ce que** les actionneurs (46, 48, 50, 52, 54, 56, 58) s'engagent sur les dispositifs de retenue de l'écran d'impression (10 ; 40) avec interposition à chaque fois d'un palier à air (78, 80, 82) et à chaque fois d'une rotule (84, 86, 88, 108, 110, 112, 114) ou d'un joint à l'état solide.

8. Station d'impression selon l'une des revendications précédentes 4 à 7, **caractérisée en ce qu'**au moins trois actionneurs (16, 18, 20 ; 46, 48, 50) s'engagent sur les dispositifs de retenue de l'écran d'impression (10 ; 40) pour générer une force de coulissement parallèle à la surface de support du support de pièce (68).

9. Station d'impression selon l'une des revendications précédentes 4 à 8, **caractérisée en ce qu'**au moins trois actionneurs (52, 54, 56, 58) s'engagent sur les dispositifs de retenue de l'écran d'impression (40) pour générer une force de coulissement perpendiculaire à la surface de support du support de pièce (68).

10. Station d'impression selon la revendication 9, **caractérisée en ce que** les dispositifs de retenue comportent un cadre de retenue (42) entourant l'écran d'impression (40), les actionneurs (52, 54, 56, 58) s'engageant au moins en partie dans la région des coins du cadre de retenue (42).

11. Station d'impression selon la revendication 9 ou 10, **caractérisée en ce que** les actionneurs (52, 54, 56, 58) sont disposés sur un côté des dispositifs de retenue qui est opposé à la surface de support du support de pièce (68).

12. Station d'impression selon l'une des revendications précédentes, **caractérisée en ce que** les dispositifs de retenue de l'écran d'impression (40) comportent des plaques de palier (92, 94, 96, 98) disposées parallèlement à l'écran d'impression (40) et chaque plaque de palier (92, 94, 96, 98) est associée à un étrier de retenue (100, 102, 104, 106) en forme de U qui s'engage par endroits autour de la plaque de palier respective (92, 94, 96, 98).

13. Station d'impression selon la revendication 12, **caractérisée en ce que** le palier à air est disposé entre un côté intérieur d'une première branche de l'étrier de retenue (100, 102, 104, 106) et la plaque de palier (92, 94, 96, 98).

14. Station d'impression selon la revendication 12 ou 13, **caractérisée en ce que** l'actionneur (52, 54, 56, 58) s'engage sur un côté extérieur d'une deuxième branche de l'étrier de retenue (100, 102, 104, 106).

15. Procédé d'impression de substrats bidimensionnels, notamment de cellules solaires (14, 44), à l'aide d'une station d'impression selon l'une au moins des revendications précédentes, **caractérisé par** le maintien à coulissement de l'écran d'impression (10 ; 40) à l'aide de paliers à air (78, 80, 82) et par le coulissement de l'écran d'impression (10 ; 40) par rapport à la surface de support du support de pièce (68) pendant l'opération d'impression.
